(19) Europäisches Patentamt
European Patent Office
Office européen des brevets

(11) **EP 3 459 147 B1**

(12) **EUROPÄISCHE PATENTSCHRIFT**

(45) Veröffentlichungstag und Bekanntmachung des Hinweises auf die Patenterteilung:
**03.04.2024 Patentblatt 2024/14**

(21) Anmeldenummer: **17726584.0**

(22) Anmeldetag: **19.05.2017**

(51) Internationale Patentklassifikation (IPC):
**H01S 5/0687** (2006.01)

(52) Gemeinsame Patentklassifikation (CPC):
**H01S 5/0687; H01S 5/3402;** H01S 5/02415

(86) Internationale Anmeldenummer:
**PCT/EP2017/062125**

(87) Internationale Veröffentlichungsnummer:
**WO 2017/198827 (23.11.2017 Gazette 2017/47)**

(54) **VERFAHREN ZUR REGELUNG DER EMISSIONSFREQUENZ EINES LASERS**

METHOD FOR CONTROLLING THE EMISSION FREQUENCY OF A LASER

PROCÉDÉ DE COMMANDE DE LA FRÉQUENCE D'ÉMISSION D'UN LASER

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.05.2016 DE 102016208754**

(43) Veröffentlichungstag der Anmeldung:
**27.03.2019 Patentblatt 2019/13**

(73) Patentinhaber: **Humedics GmbH**
**10717 Berlin (DE)**

(72) Erfinder:
- **LUCHTERHAND, Axel**
  **12101 Berlin (DE)**
- **HELMKE, Alexander**
  **12159 Berlin (DE)**
- **RUBIN, Tom**
  **12163 Berlin (DE)**
- **HEYNE, Karsten**
  **14547 Beelitz - OT Buchholz (DE)**

(74) Vertreter: **Maikowski & Ninnemann**
**Patentanwälte Partnerschaft mbB**
**Postfach 15 09 20**
**10671 Berlin (DE)**

(56) Entgegenhaltungen:
**EP-A1- 0 665 660         US-A1- 2002 097 760**
**US-A1- 2002 097 760     US-A1- 2003 174 743**

- **STROBEL O ET AL: "AUTOMATIC START-UP PROCEDURE FOR LASER WAVELENGTH STABILIZATION", INTERNATIONAL CONFERENCE ON INTEGRATED OPTICS AND OPTICAL FIBRE COMMUNICATION (IOOC) AND EUROPEAN CONFERENCE ON OPTICAL COMMUNICATION (ECOC). VENICE, OCT. 1 - 4, 1985; [INTERNATIONAL CONFERENCE ON INTEGRATED OPTICS AND OPTICAL FIBRE COMMUNICATION (IO, vol. CONF. 5, 11, no. 1985, 1 October 1985 (1985-10-01), pages 413-416, XP000011616,**

**Beschreibung**

Die vorliegende Erfindung betrifft ein Verfahren zur Regelung der Emissionsfrequenz eines Lasers.

Laser werden beispielsweise in der Spektroskopie eingesetzt. Die Emissionsfrequenz eines Lasers ist die Frequenz des Lichts, das der Laser emittiert. Durch äußere Einflüsse verändern Laser ihre Eigenschaften. Dies führt insbesondere zur Änderung der Lichtfrequenz (Emissionsfrequenz). Die Änderungen der Lichtfrequenz können in Bereichen von hunderten Wellenzahlen liegen; bei gut eingestellten Lasern liegen sie bei nur wenigen Wellenzahlen oder noch kleiner.

Bei spektral hochaufgelösten Messungen können allerdings auch Frequenzschwankungen von weniger als einer Wellenzahl deutliche Probleme machen. Beispielsweise sind Halbleiterlaser im infraroten Spektralbereich oder auch Quantenkaskadenlaser sehr schmalbandige Lichtquellen mit einer Halbwertsbreite von weniger als 1 $cm^{-1}$ (auch 0,01 $cm^{-1}$ oder besser). Obwohl diese Laser meistens temperaturstabilisiert sind, führen Änderungen der Temperatur in der Umgebung zu Frequenzänderungen des Lasers. Diese Änderungen können sehr klein sein, bis hin zu wenigen Wellenzahlen, z.B. 0,005 $cm^{-1}$, 0,01 $cm^{-1}$, 0,02 $cm^{-1}$, 0,05 $cm^{-1}$, 0,1 $cm^{-1}$, 0,2 $cm^{-1}$ oder größer.

Bei einem Quantenkaskadenlaser (QCL), wie etwa einem DFB-Laser (DFB steht für den Fachbegriff "distributed feedback"), der in einem Spektralbereich mit einer Breite von etwa 30 $cm^{-1}$ Laserlicht mit einer Emissionsfrequenzbreite von etwa 0,01 $cm^{-1}$ erzeugen kann, hängt die Emissionsfrequenz stark von der Schichtdicke und Abfolge der einzelnen Schichten im Lasermedium ab. Dadurch wird nur ein kleiner Spektralbereich aus der gesamten spektralen Breite (von etwa 30 $cm^{-1}$) verstärkt. Auch bei anderen Lasern (beispielsweise bei ICL (ICL steht für den Fachbegriff "interband cascade laser")) liegen ähnliche Abhängigkeiten vor. Durch Änderung der Temperatur des Lasers ändert sich die Schichtdicke durch thermische Ausdehnung, aber auch die Brechzahl des Lasermediums. Damit ändert sich die Emissionsfrequenz des Lasers (nachfolgend auch verkürzt als Laserfrequenz bezeichnet). Diese Abhängigkeit macht man sich sehr oft zu Nutze, indem am Lasermedium eine Heizspannung angelegt wird. Als Heizspannung ist das Anlegen einer Spannung bzw.

Stromstärke an den Laser zu verstehen. Diese Spannung oder Stromstärke führt aufgrund des ohmschen Gesetzes zu einem Aufheizen des Lasers, wodurch sich die Temperatur und auch die Laserfrequenz verändern. Die Spannung oder die Stromstärke kann dabei konstant sein, linear ansteigen oder eine Modulation aufweisen.

Es ist also schon lange bekannt, dass die Temperaturvariation die Emissionsfrequenz des Lasers verändert. Somit kann man durch Temperaturvariation, die beispielsweise durch einen Stromfluss durch den Laser erzeugt wird, die Emissionsfrequenz verändern und ein Spektrum messen.

Eine einzelne Messung des Spektrums kann damit einfach durchgeführt werden. Allerdings werden in der Praxis alle Experimente (mehrfach) wiederholt, um eine Statistik von Messergebnissen mit Fehlerbetrachtung und eine Verbesserung des Signal-Rausch-Verhältnisses zu erreichen.

Zwei Messungen des Spektrums sind aber nur vergleichbar, wenn der Frequenzbereich übereinstimmt, die Frequenzabstände einzelner Messpunkte übereinstimmen und die Messwerte verglichen werden können. Das Experiment muss unter denselben Bedingungen wiederholt werden können. Das ist nicht der Fall, wenn sich die Eigenschaften des Lasers ändern und damit beispielsweise der Frequenzbereich und andere Eigenschaften, wie die absolute Position der Emissionsfrequenz, der Untergrund und die Nichtlinearität der Lasereigenschaften.

Zur Temperaturstabilisierung eines Lasers wird regelmäßig ein Peltierelement eingesetzt, das den Laser erwärmen oder kühlen kann. Dazu wird die Temperatur an einem Kupferblock gemessen, auf dem der Laser montiert ist. Allerdings ist dies mit einer gewissen Ungenauigkeit verbunden, da der Kupferblock eine Temperaturänderung des Lasers nur mit einer Verzögerung wiedergibt. Ferner können sich externe Einflüsse, die auf den Kupferblock wirken, störend bei einer exakten Temperaturbestimmung des Lasers auswirken.

Aus der EP 0 845 166 B1 ist ein Laserwellenlängen-Regelungssystem zum Stabilisieren einer Laserausgangs-Wellenlänge bekannt. Dieses System weist eine Reflektor/Filter-Vorrichtung und eine Steuerung auf. Die Steuerung verwendet ein Signal, das die Reflektor/FilterVorrichtung passiert hat, und ein Signal, das von der Reflektor/Filter-Vorrichtung reflektiert wurde, zum Stabilisieren der Laserausgangs-Wellenlänge. Bei der in jenem europäischen Patent beschriebenen Lösung ist also ein zusätzliches optisches Element in Form der Reflektor/Filter-Vorrichtung erforderlich, um die Laserausgangs-Wellenlänge zu stabilisieren.

Die US 2002/0097760 A1 beschreibt ein Verfahren und ein System, die dazu dienen, einen weit abstimmbaren Laser (WTL) auf einer ausgewählten Übertragungswellenlänge zu halten.

Die US 2003/0174743 A1 beschreibt ein Verfahren und ein System zur Filterung eines Benutzerlichtstrahls unter Verwendung eines periodischen Filters mit einem Frequenzgang, der auf einen absolut kalibrierten Wert stabilisiert ist.

Strobel und Graf (O. Strobel und N. Graf, "AUTOMATIC START-UP PROCEDURE FOR LASER WAVELENGTH STABILIZATION", 5th INTERNATIONAL CONFERENCE ON INTEGRATED OPTICS AND OPTICAL FIBRE COMMUNICATION, 11th EUROPEAN CONFERENCE ON OPTICAL COMMUNICATION, Venezia, October 1-4, 1985, Fondazione Giorgio Cini - Island of S. Giorgio Maggiore, 413-416) beschreiben ein Verfahren zur automatischen Fixierung der Laserwellenlänge an einem konventionellen Fabry-Pérot-Interferometer (FPI) durch automatische Wahl der richtigen Betriebspunkte der Laser-Eingabeparameter "Strom" und "Temperatur".

Der vorliegenden Erfindung liegt die Aufgabe zugrunde, ein Verfahren zur Regelung der Emissionsfrequenz eines Lasers anzugeben, das die zuvor diskutierten Nachteile überwindet und eine genauere Regelung der Emissionsfrequenz erlaubt.

Diese Aufgabe wird mit einem Verfahren mit den Merkmalen des Anspruchs 1 gelöst. Ein solches Verfahren ermöglicht es, die Temperatur des Lasers über spektrale Eigenschaften zu bestimmen, sodass Umgebungseinflüsse, die sich beispielsweise aus einer uneinheitlichen Temperaturverteilung im Kupferblock oder aus einer ungenauen Verlötung eines Temperaturfühlers am Kupferblock ergeben können, vollkommen ausgeblendet werden. Vielmehr wird durch das vorliegende Verfahren ein objektives Maß für die Temperatur eines Lasers bereitgestellt, nämlich die Emissionsfrequenz des Lasers selber.

Das erfindungsgemäß beanspruchte Verfahren zur Regelung der Emissionsfrequenz eines Lasers zeichnet sich durch mehrere Schritte aus. Zunächst kann optional eine Arbeitstemperatur des Lasers auf einen definierten Temperaturwert eingestellt werden. Dieser Temperaturwert kann den jeweiligen Anforderungen entsprechend ausgewählt werden.

Nun beginnt das eigentliche Verfahren mit der Aufnahme eines ersten Spektrums einer Probe, um Messwerte des ersten Spektrums zu erhalten. Dazu wird ein von dem Laser emittiertes Licht durch die Probe hindurch auf einen Detektor geleitet. Der Detektor ist mit einem Vielkanalanalysator verbunden, welcher die einzelnen, von dem Detektor detektierten Impulse jeweils einem Kanal zuordnet. Die Auswahl der Kanäle kann beispielsweise in Abhängigkeit eines Stromflusses durch den Laser und einer damit einhergehenden Frequenzverschiebung der Emissionsfrequenz des Lasers ausgewählt werden. Bei dem Spektrum kann es sich beispielsweise um ein Absorptionsspektrum, ein Signal- oder Transmissionsspektrum handeln. In dem Spektrum sind unterschiedliche Signale enthalten, die aus einer Interaktion der Probe mit dem eingestrahlten Laserlicht resultieren. Im Falle eines Absorptionsspektrums handelt es sich bei den Signalen um Absorptionsbanden. Die Signale können alternativ auch als Peaks, Absorptionslinien oder Linien bezeichnet werden.

Nun wird ein erster Kanal bestimmt, dem das Maximum eines ersten Signals in dem ersten Spektrum durch den Vielkanalanalysator zugeordnet wurde. Vorzugsweise handelt es sich beim ersten Kanal um einen Kanal mit niedriger Ordnungsnummer, da bei einem solchen Kanal externe Einflüsse, die beispielsweise durch einen unterschiedlich starken Stromfluss (z.B. eine linear ansteigende Stromstärke) durch den Laser hervorgerufen werden, verhältnismäßig gering sind. Anschließend wird ein zweiter Kanal bestimmt, dem das Maximum eines zweiten Signals in dem ersten Spektrum zugeordnet wurde. Im Rahmen des vorliegend beanspruchten Verfahrens werden also zumindest zwei Signale, wie etwa zwei Absorptionsbanden, ausgewertet. Grundsätzlich ist es jedoch möglich, mit mehr als zwei Signalen, etwa mit 3, 4, 5, 6, 7, 8, 9, 10 oder mehr Signalen zu arbeiten.

Nun wird ein zweites Spektrum in analoger Weise wie das erste Spektrum aufgenommen, um Messwerte des zweiten Spektrums zu erhalten. Das heißt, es wird dieselbe Probe unter denselben Bedingungen mit demselben Laser, demselben Detektor und demselben Vielkanalanalysator aufgenommen. Unter Idealbedingungen müsste das zweite Spektrum nun exakt dem ersten Spektrum entsprechen. Unter Realbedingungen kann es jedoch zu Abweichungen zwischen dem ersten Spektrum und dem zweiten Spektrum kommen, insbesondere wenn zwischen der Aufnahme des ersten Spektrums und des zweiten Spektrums ein längerer Zeitraum liegt, in dem der Laser beispielsweise durch wiederholte Messungen eine Temperaturveränderung erfahren hat.

Nun wird ermittelt, ob das Maximum des ersten Signals in dem zweiten Spektrum abermals dem ersten Kanal zugeordnet wurde (wie das Maximum des ersten Signals im ersten Spektrum). Dabei entspricht das erste Signal des zweiten Spektrums dem ersten Signal des ersten Spektrums. Ferner wird ermittelt, ob das Maximum des zweiten Signals in dem zweiten Spektrum dem zweiten Kanal zugeordnet wurde (wie das Maximum des zweiten Signals in dem ersten Spektrum). Dabei entspricht das zweite Signal in dem zweiten Spektrum auch dem zweiten Signal in dem ersten Spektrum. Zu dieser Ermittlung bieten sich unterschiedliche Vorgehensweisen an, die weiter unten noch erläutert werden.

Anschließend wird die Arbeitstemperatur des Lasers angepasst, wenn im zuvor erläuterten Ermittlungsschritt Abweichungen ermittelt wurden. Die Anpassung erfolgt dabei derart, dass das Maximum des ersten Signals in dem zweiten Spektrum dem ersten Kanal zugeordnet wird. Alternativ oder zusätzlich wird infolge der Anpassung das Maximum des zweiten Signals in dem zweiten Spektrum dem zweiten Kanal zugeordnet. Hierfür kann optional auch eine gesonderte Anpassung erfolgen.

Durch dieses Verfahren wird also eine spektrale Information (nämlich eine Abweichung der Lage des Maximums des ersten Signals bzw. der Lage des Maximums des zweiten Signals durch einen Vergleich des ersten Spektrums mit dem zweiten Spektrum) dazu verwendet, die Arbeitstemperatur des Lasers so anzupassen, dass ein weiteres, nach dem zweiten Spektrum aufgenommenes Spektrum hinsichtlich des Maximums des ersten Signals und/oder des Maximums des zweiten Signals exakt dem ersten Spektrum entspricht. Wenn das erreicht wurde, bedeutet dies, dass die Emissionsfrequenz des Lasers denselben Wert wie bei der Aufnahme des ersten Spektrums aufweist. Es findet also eine adaptive Feedback-Regelung statt, die es auf der Grundlage objektiver, lediglich vom Laser selbst abhängiger Eigenschaften ermöglicht, die Emissionsfrequenz des Lasers exakt einzustellen.

Als erstes Signal und/oder als zweites Signal können insbesondere beliebige Absorptionsbanden eines Gases verwendet werden. Das beschriebene Verfahren eignet sich zur Anwendung in unterschiedlichen Spektroskopieverfahren. Beispielsweise kann es für spektroskopische Verfahren im mittleren Infrarotbereich oder im nahen Infrarotbereich eingesetzt werden. Bei dem ersten Signal und dem zweiten Signal kann es sich beispielsweise um eine Rotationsbande, eine Rotationsvibrationsbande oder um Obertöne solcher Banden handeln.

Je geringer die Halbwertsbreite eines Signals ist, desto besser eignet es sich zur Verwendung in dem beschriebenen Regelungsverfahren. Beispielsweise kann eine Referenzzelle verwendet werden, in der ein Gas mit einem niedrigen Druck vorgehalten wird. Dadurch ergibt sich eine schmale Linienbreite und damit eine besonders vorteilhafte Regelung der Emissionsfrequenz des eingesetzten Lasers.

Alternativ können auch andere Messmethoden verwendet werden, um die Frequenzposition des Lasers zu ermitteln. Anstelle der Position von Absorptionsbanden können auch Messergebnisse eines Spektrometers, eines Etalons (beispielsweise eines Fabry-Pérot-Etalons), oder einer frequenzselektiven Photodiode für eine Feedback-Regelung eingesetzt werden. Diese genannten Methoden sind allerdings meist sehr umständlich und müssen zusätzlich eingesetzt werden. Ein besonderer Vorteil des Verfahrens ist, dass die Messungen an dem untersuchten Gas direkt zur Frequenzregelung eingesetzt werden können und die Regelung eine hohe absolute Genauigkeit aufweist. Diese hohe Genauigkeit wird schon bei einer einzelnen Messung erreicht, die innerhalb von $0{,}5 * 10^{-6}$ Sekunden durchgeführt werden kann. Ein einzelnes Spektrum kann in dieser Zeit aufgenommen werden und spektrale Genauigkeiten von $0{,}01 \ cm^{-1}$ erreicht werden.

Da zur Regelung der Emissionsfrequenz eine spektrale Eigenschaft des Lasers verwendet wird (statt einer externen Temperaturmessung gemäß den Lösungen des Stands der Technik) ist das vorstehend beschriebene Verfahren unabhängig von Temperatursensoren. Dies betrifft sowohl die Art des Temperatursensors als auch dessen Positionierung gegenüber dem Laser. Ungenauigkeiten, die bei den aus dem Stand der Technik bekannten Verfahren durch inhärente Ungenauigkeiten der eingesetzten Temperatursensoren sowie aus Positionsdifferenzen des Temperatursensors gegenüber dem Laser resultierten, spielen bei dem vorliegend beanspruchten Verfahren keine Rolle mehr. Ferner ist das vorliegend beanspruchte Verfahren unabhängig von Störeinflüssen eines unbekannten Wärmeeintrags aus der Umgebung. Ein derartiger Wärmeeintrag am Temperatursensor führt bei den aus dem Stand der Technik bekannten Lösungen dazu, dass der verwendete Temperatursensor stets eine Mischtemperatur aus der Lasertemperatur und der Umgebungstemperatur misst. Dies führt dazu, dass es in der Regel Unterschiede zwischen der Solltemperatur, also dem Arbeitspunkt des Lasers, und der Isttemperatur, also der aktuellen Temperatur des Lasers, gibt. Das heißt, dass der Laser in der Regel ohne Korrektur nicht an seinem Arbeitspunkt operiert. Nur dann, wenn die Umgebungstemperatur konstant bleibt, wird bei den aus dem Stand der Technik bekannten Lösungen eine akzeptable Temperaturnachregulierung des Lasers erreicht. Demgegenüber blendet das vorliegend beanspruchte Verfahren derartige Störeinflüsse vollkommen aus; es berücksichtigt lediglich interne, spektrale Eigenschaften des Lasers zu dessen Temperaturregulierung.

In einer Variante des Verfahrens wird dann, wenn in dem Schritt, in dem ermittelt wird, ob das Maximum des ersten Signals und das Maximum des zweiten Signals im ersten und im zweiten Spektrum übereinstimmen, Abweichungen festgestellt werden, ein zusätzlicher Laserparameter angepasst. Dieser zusätzliche Laserparameter bewirkt eine Dehnung oder Stauchung eines Spektrums, das mittels des Lasers aufgenommen wird. Folglich kann über die Temperaturanpassung die Lage eines Signals im Spektrum angepasst werden. Wenn sich nach dieser Anpassung das zweite Signal im Spektrum an der erwarteten (gewünschten) Position befindet, ist keine weitere Anpassung des Spektrums erforderlich. Stimmt jedoch der relative Abstand zwischen dem ersten Signal und dem zweiten Signal nicht mit dem Erwartungswert überein, muss eine Stauchung oder eine Dehnung des Spektrums erfolgen. Ebendies lässt sich über den zusätzlich anpassbaren Laserparameter einstellen. Bei diesem Laserparameter kann es sich beispielsweise um eine Stromstärke handeln, die an den Laser angelegt wird.

Die Arbeitstemperatur des Lasers kann beispielsweise über ein Peltier-Element beeinflusst werden. Ein derartiges Peltier-Element wird typischerweise durch eine Steuerung gesteuert, die eine Eingangsgröße empfängt. Diese Eingangsgröße kann in Abhängigkeit der ermittelten Abweichungen der tatsächlichen Lage mindestens eines Maximum im zweiten Spektrum von der erwarteten Lage derart angepasst werden, dass die Lasertemperatur erhöht oder abgesenkt wird, sodass die Emissionsfrequenz des Lasers wieder dem gewünschten Wert entspricht.

In einer Variante ist es möglich, die Anpassung des Laserparameters abhängig von der Anpassung der Arbeitstemperatur des Lasers bzw. des Temperaturregelparameters des Lasers zu machen. Auf diese Weise können Informationen, die sich aus der Anpassung der Arbeitstemperatur des Lasers ergeben (insbesondere eine erwartete Verschiebung des Spektrums) dazu verwendet werden, den Laserparameter entsprechend geringer nachzuregeln, als dies ohne Berücksichtigung der Anpassung der Arbeitstemperatur erforderlich wäre. Dadurch lässt sich eine schnellere und effizientere Anpassung der Emissionsfrequenz des Lasers erreichen, die letztlich in einem exakten Spektrum resultiert.

In einer Variante wird das Ermitteln, ob das Maximum des ersten Signals und das Maximum des zweiten Signals im zweiten Spektrum jeweils demselben Kanal wie im ersten Spektrum zugeordnet wurden, durch die nachfolgend erläuterten Schritte ausgeführt.

Zunächst wird für den ersten Kanal und für eine vorbestimmbare Anzahl weiterer Kanäle, die dem ersten Kanal benachbart sind, ein erster Wert bestimmt. Dieser erste Wert ist dabei repräsentativ für eine den Kanälen zugeordnete Signalintensität. Dabei ist zu berücksichtigen, dass die benachbarten Kanäle eine höhere Ordnungszahl aufweisen als der erste Kanal, in einem Spektrum also rechts des ersten Kanals angeordnet sind. Bildlich gesprochen, spiegeln die Signalintensitäten, die diesen Kanälen zugeordnet wurden, die absteigende Flanke eines Signals wieder.

Ferner wird für den ersten Kanal und für eine vorbestimmbare Anzahl dem ersten Kanal benachbarter weiterer Kanäle ein zweiter Wert bestimmt, der repräsentativ für eine Signalintensität ist, die diesen Kanälen zugeordnet ist. Dabei handelt es sich bei den benachbarten Kanälen in diesem Fall um Kanäle mit niedrigerer Ordnungszahl als der erste Kanal. Abermals bildlich gesprochen, spiegeln die Signalintensitäten, die diesen Kanälen niedrigerer Ordnungszahl zugeordnet sind, die in einem Spektrum links des Maximums angeordnete aufsteigende Flanke eines Signals wieder.

Anschließend wird ein Verhältnis zwischen dem ersten Wert und dem zweiten Wert gebildet (beispielsweise erster Wert dividiert durch den zweiten Wert). Auf diese Weise lässt sich feststellen, ob die ansteigende, linke Flanke eines Signals oder ob die absteigende, rechte Flanke eines Signals eine größere Signalintensität aufweist. Dabei kann beispielsweise eine Integration über die Signalintensitäten vorgenommen werden, sodass die Flächen eines etwa mittig aufgeteilten Signals miteinander verglichen werden.

Wenn das Verhältnis der beiden Werte zueinander einen vorgegebenen Zahlenwert, z.B. 1, beträgt, ist das Maximum des betreffenden Signals nach wie vor dem ersten Kanal zugeordnet. Ist das Verhältnis des ersten Werts zu dem zweiten Wert größer als der vorgegebene Zahlenwert (z.B. 1), ist das Maximum des Signals im Spektrum nach rechts (zu einem Kanal mit höherer Ordnungszahl) gewandert. Ist das Verhältnis von dem ersten Wert zu dem zweiten Wert kleiner als der vorgegebene Zahlenwert (z.B. 1), ist das Maximum des ersten Signals im Spektrum nach links (zu einem Kanal mit niedrigerer Ordnungszahl) gewandert.

Durch das Bilden eines Verhältnisses zwischen dem ersten Wert und dem zweiten Wert werden absolute Änderungen der Signalintensität gegeneinander weggekürzt. Absolute Signaländerungen treten z.B. durch Konzentrationsänderungen oder in Gasabsorptionsspektren durch Temperatur- und Druckänderungen auf. Hierbei ändern sich der erste und zweite Wert proportional zueinander und das Verhältnis der Werte ändert sich nicht. Relative Änderungen der Signalintensität (und damit die beobachtete Lage des Signals in dem Spektrum) können jedoch nach wie vor beobachtet werden. Bei einer Änderung der Lage des Signals ändern sich der erste und zweite Wert nicht mehr proportional zueinander, sondern führen zu einer Änderung des Verhältnisses.

In einer Variante wird das erste Verhältnis dazu verwendet, einen Temperaturregelparameter des Lasers anzupassen. Ein solcher Temperaturregelparameter wird üblicherweise in Abhängigkeit eines von einem Temperatursensor gelieferten Temperaturwerts bestimmt. Das heißt, die Temperaturregelung des Lasers erwartet einen derartigen Temperaturregelparameter als Eingangsgröße. Wenn dieser Temperaturregelparameter nun unmittelbar durch das erste Verhältnis angepasst wird, kann unmittelbarer Einfluss auf die Temperaturregelung des Lasers genommen werden. Beispielsweise kann der Temperaturregelparameter durch Addition eines Korrekturterms, in den das erste Verhältnis einfließt, angepasst werden.

In einer Variante wird zum Ermitteln, ob das Maximum des ersten Signals und das Maximum des zweiten Signals in dem zweiten Spektrum dieselbe Lage wie in dem ersten Spektrum aufweisen, alternativ oder zusätzlich die nachfolgend erläuterten Schritte durchgeführt. Zunächst wird für den zweiten Kanal und für eine vorbestimmbare Anzahl dem zweiten Kanal benachbarter Kanäle ein dritter Wert bestimmt. Dieser dritte Wert ist dabei repräsentativ für eine diesen Kanälen zugeordnete Signalintensität. Ähnlich wie beim ersten Wert handelt es sich bei den benachbarten Kanälen auch im Fall des dritten Werts um Kanäle mit höherer Ordnungszahl (also solche Kanäle, die in einem Spektrum rechts des zweiten Kanals angeordnet sind).

Anschließend wird für den zweiten Kanal und für eine vorbestimmbare Anzahl dem zweiten Kanal benachbarter Kanäle ein vierter Wert bestimmt. Auch der vierte Wert ist dabei repräsentativ für eine Signalintensität, die diesen Kanälen zugeordnet wurde. Bei den dem zweiten Kanal benachbarten Kanälen handelt es sich im Fall des vierten Werts, ähnlich wie beim zweiten Wert, um Kanäle mit niedrigerer Ordnungszahl (also solche Kanäle, die in der grafischen Darstellung des Spektrums links des zweiten Kanals dargestellt sind).

Nun wird zwischen dem dritten Wert und dem vierten Wert ein zweites Verhältnis gebildet (beispielsweise dritter Wert dividiert durch vierter Wert).

Der erste Wert, der zweite Wert, der dritte Wert und/oder der vierte Wert können unabhängig voneinander beispielsweise die Fläche eines Teils eines Signals in einem Spektrum widerspiegeln. Zu diesem Zweck kann über die entsprechenden Abschnitte des Signals integriert werden, um den entsprechenden Flächenwert zu erhalten.

Der erste Wert, der zweite Wert, der dritte Wert und/oder der vierte Wert könnten aber auch Werte sein, die sich aus einer Ableitung, wie etwa der ersten Ableitung oder der zweiten Ableitung des Spektrums, ergeben. Im letzteren Fall würde der zentrale Kanal dem Wert 0 der ersten Ableitung entsprechen, wobei den Kanälen mit höherer Ordnungszahl ein positiver Wert der ersten Ableitung und den Kanälen mit niedrigerer Ordnungszahl ein negativer Wert der ersten Ableitung zugeordnet würde. Es kommt letztlich nicht darauf an, welches mathematische Verfahren verwendet wird, um den ersten Wert, den zweiten Wert, den dritten Wert und/oder den vierten Wert zu bestimmen. Wichtig ist lediglich, dass diese Werte ihren Ursprung in der Signalintensität haben, die einem Kanal zugeordnet wurde.

In einer Variante wird das zweite Verhältnis dazu verwendet, einen Laserparameter anzupassen. Bei diesem Laserparameter handelt es sich um einen solchen Parameter, der eine Dehnung oder Stauchung eines Spektrums bewirkt, das mithilfe des Lasers aufgenommen wurde. Während also über die Arbeitstemperatur des Lasers die Position eines Signals im Spektrum eingestellt werden kann, lässt sich über eine Dehnung oder Stauchung des Spektrums der relative Abstand zweier Signale zueinander beeinflussen. Auf diese Weise lässt sich der Laser sehr fein anpassen, sodass nacheinander folgende Messungen unter identischen Laserbedingungen durchgeführt werden können.

Bildlich gesprochen, können über die Auswahl der benachbarten Kanäle, die den ersten Kanal und/oder den zweiten Kanal umgeben, die Flanken eines Signals bzw. Peaks in einem Spektrum definiert werden, die zur Auswertung der Lage des Signals herangezogen werden. Dabei kann es - je nach konkreter Ausgestaltung des Signals - sinnvoll sein, eine asymmetrische Aufteilung der benachbarten Kanäle mit höherer Ordnungszahl und der benachbarten Kanäle mit niedrigerer Ordnungszahl zu wählen. Die Anzahl der benachbarten Kanäle mit höherer Ordnungszahl kann also größer oder kleiner als die Anzahl der benachbarten Kanäle mit niedrigerer Ordnungszahl sein.

In einer Variante ist es indes vorgesehen, dass die Anzahl der benachbarten Kanäle mit niedrigerer Ordnungszahl der Anzahl der Kanäle mit höherer Ordnungszahl als der erste Kanal bzw. der zweite Kanal entspricht. In einem solchen Fall werden also oberhalb und unterhalb des Kanals (bei grafischer Darstellung: rechts und links des Kanals), in dem das Signalmaximum liegen soll, gleich viele Kanäle ausgewählt. Abermals bildlich gesprochen, wird eine symmetrische Auswertung der einzelnen Signale des Spektrums angewendet.

Es ist denkbar und vorgesehen, dass in einer Variante für das erste Signal die Anzahl der benachbarten Kanäle mit niedrigerer Ordnungszahl der Anzahl der Kanäle mit höherer Ordnungszahl entspricht, für das zweite Signal jedoch voneinander abweicht, oder umgekehrt.

Das erste Verhältnis und/oder das zweite Verhältnis können in einer Variante nur für das zweite Spektrum berechnet werden. In einer anderen Variante werden das erste Verhältnis und/oder das zweite Verhältnis sowohl für das erste Spektrum als auch für das zweite Spektrum berechnet. Dann lassen sich Änderungen der Signallage im aufgenommenen Spektrum besonders leicht detektieren. Wenn das erste Verhältnis und/oder das zweite Verhältnis auch für das erste Spektrum berechnet werden soll, wird analog zur Berechnung des entsprechenden Verhältnisses für das zweite Spektrum vorgegangen. Diese Berechnung kann beispielsweise dann erfolgen, wenn der erste Kanal und/oder der zweite Kanal bestimmt wurden.

Neben der Berechnung des ersten Verhältnisses und/oder des zweiten Verhältnisses (die im Hinblick auf eine spektrale Auswertung der Division einer ersten Teilfläche des ersten Signals durch eine zweite Teilfläche des ersten Signals bzw. der Division einer ersten Teilfläche des zweiten Signals durch eine zweite Teilfläche des zweiten Signals entsprechen) existieren grundsätzlich auch andere Möglichkeiten, um zu ermitteln, ob das Maximum des ersten Signals in dem zweiten Spektrum dem ersten Kanal zugeordnet wurde und ob das Maximum des zweiten Signals in dem zweiten Spektrum dem zweiten Kanal zugeordnet wurde.

In einer Variante erfolgt dieses Ermitteln dadurch, dass zunächst ein dritter Kanal bestimmt wird, dem das Maximum des ersten Signals in dem zweiten Spektrum zugeordnet wurde. Alternativ oder zusätzlich wird ein vierter Kanal bestimmt, dem das Maximum des zweiten Signals in dem zweiten Spektrum zugeordnet wurde.

In jedem Fall wird in dieser Variante dann ermittelt, ob der dritte Kanal dem ersten Kanal entspricht und/oder ob der vierte Kanal dem zweiten Kanal entspricht. Wenn dem so ist, braucht keine Anpassung des Lasers zu erfolgen. Im Falle von Abweichungen können die oben beschriebenen Anpassungen des Lasers vorgenommen werden, sodass das Maximum des ersten Signals wieder im ersten Kanal (also dem gewünschten Sollwert) detektiert wird und/oder sodass das Maximum des zweiten Signals wieder im zweiten Kanal (also dem gewünschten Sollwert) detektiert wird.

Diese Variante lässt sich in einer Ausgestaltung besonders vorteilhaft dadurch ausführen, dass der dritte Kanal und/oder der vierte Kanal durch eine Kurvenanpassung bestimmt werden. Zu diesem Zweck wird eine Kurve an die Messwerte des zweiten Spektrums angepasst; es wird also ein mathematischer Fit der Messwerte durchgeführt. Ein dem Maximum des ersten Signals entsprechendes Maximum der Kurve wird dann dazu verwendet, den dritten Kanal zu bestimmen. Alternativ oder zusätzlich wird ein dem Maximum des zweiten Signals entsprechendes Maximum der Kurve zur Bestimmung des vierten Kanals verwendet.

Alle vorgenannten Varianten können in beliebiger Weise miteinander kombiniert werden.

Weitere Vorteile und Einzelheiten der vorliegenden Erfindung werden anhand von Ausführungsbeispielen und Figuren näher erläutert. Es zeigen:

Figur 1   ein simuliertes Absorptionsspektrum von Kohlendioxidgas im Spektralbereich von 2299 cm$^{-1}$ bis 2295 cm$^{-1}$;

Figur 2   einen ausgewählten Spektralbereich der $^{12}CO_2$-Bande und der $^{13}CO_2$-Bande in einem IR-Absorptionsspektrum;

Figur 3    ein Beispiel der Vorgehensweise zur Ermittlung einer möglichen Abweichung der Lage der beiden dargestellten Absorptionsbanden von einer Lage in einem zuvor aufgenommenen Spektrum;

Figur 4    eine graphische Darstellung eines Ausführungsbeispiels der Abhängigkeit des Parameters TempSet von dem Verhältnis A/B der Flankenintegrale einer ersten Absorptionsbande;

Figur 5    eine graphische Darstellung eines Ausführungsbeispiels der Abhängigkeit des Parameters Imax von dem Verhältnis C/D der Flankenintegrale einer zweiten Absorptionsbande; und

Figur 6    eine graphische Darstellung typischer Verläufe von Flankenverhältnissen zweier Absorptionsbanden in Abhängigkeit der Zeit unter realen Messbedingungen bei Anwendung eines Ausführungsbeispiels des Verfahrens zur Regelung der Emissionsfrequenz eines Lasers.

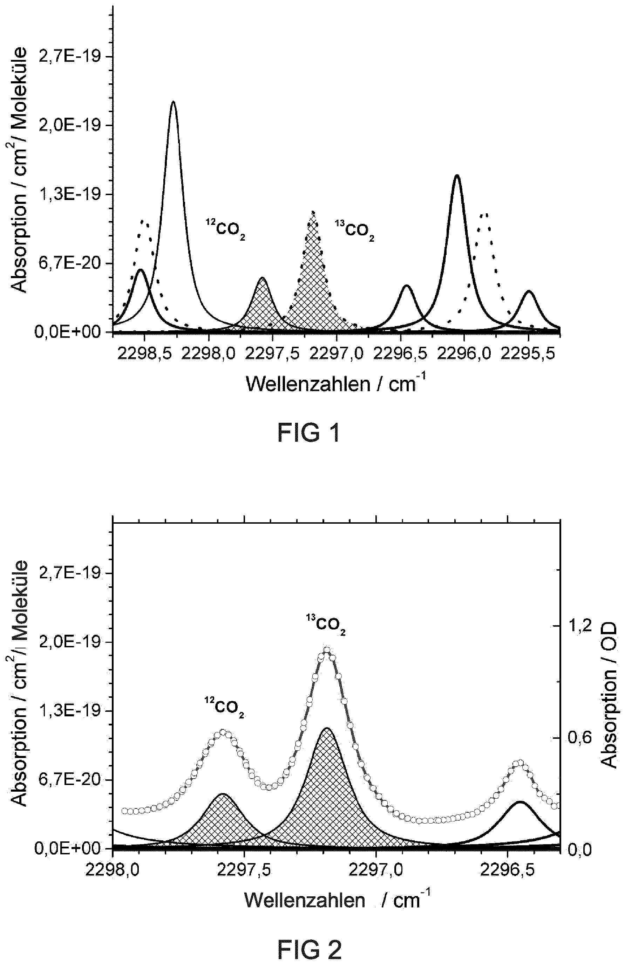

Die Figur 1 zeigt ein simuliertes Absorptionsspektrum (unter Anwendung des Lambert-Beer-Gesetzes) von Kohlendioxidgas, wobei $^{12}CO_2$-Banden mit einer durchgezogenen Linie und $^{13}CO_2$-Banden mit einer gestrichelten Linie dargestellt sind.

Typischerweise wird der zu messende Spektralbereich von einer Anfangsfrequenz bis zu einer Endfrequenz durchgestimmt. Wird die Frequenz durch eine schnelle Temperaturänderung des Lasers, z.B. durch einen Stromdurchfluss, erzeugt, dann gibt es eine Anfangs- und Endtemperatur, die mit einer Anfangs- und Endfrequenz zusammenhängen. Allerdings ist die Abhängigkeit zwischen angelegter Heizspannung und Emissionsfrequenz nicht linear, so dass entweder bei jeder Messung eine Kalibrierung (z.B. mit einem Germaniumetalon) durchgeführt werden muss, oder aber mindestens zwei Absorptionslinien eindeutig identifiziert werden müssen, deren Frequenzpositionen bekannt sind.

Die Frequenzpositionen von typischen Gasabsorptionslinien sind sehr genau bekannt und können beispielsweise in der HITRAN-Datenbank (online zugänglich über die Internetseite http://hitran.org/) mit Unsicherheiten kleiner einer tausendstel Wellenzahl nachgeschlagen werden.

Die eingangs diskutierten Änderungen der Eigenschaften des Lasers bzw. der Laserumgebung (z.B. Temperatur, Druck, Luftfeuchtigkeit, Stromfluss, Spannung) führen sehr oft zu einer systematischen Drift zu höheren oder niedrigeren Frequenzen. Häufig oszilliert die Emissionsfrequenz des Lasers auch um den eingestellten Frequenzwert. Am Beispiel eines Rotations-Vibrations-Absorptionsspektrums von Kohlendioxid in der Gasphase, das experimentell mit einem schmalbandigen Infrarotlaser (IR-Laser) aufgenommen wird, kann die damit verknüpfte technische Herausforderung gut dargestellt werden. Es sei angenommen, dass in diesem Beispiel nur die Temperatur die Lasereigenschaften eines Quantenkaskadenlasers (als Lichtquelle) ändert.

Die in Figur 1 dargestellten Absorptionslinien beruhen auf Daten, die aus der HITRAN-Datenbank übernommen wurden. Die Linienbreite der Absorptionslinien beträgt 0,19 cm$^{-1}$ und ergibt sich aus der natürlichen Linienbreite, den natürlichen Verbreiterungen und der Verbreiterung aufgrund der Messapparatur.

Im Folgenden werden nun eine beispielhafte Messung und eine exakte Regelung der Laserfrequenz dargestellt.

Ziel der Messung soll die Bestimmung der Konzentration von $^{12}CO_2$ und $^{13}CO_2$ in einer Probe sein. Der ausgewählte Spektralbereich erstreckt sich von 2298 cm$^{-1}$ bis 2296,3 cm$^{-1}$ und ist in der Figur 2 dargestellt. Die simulierte $^{13}CO_2$-Absorptionsbande und die simulierte $^{12}CO_2$-Absorptionsbande sind mit einer Kreuzschraffur und einer entsprechenden Beschriftung gekennzeichnet. Die mit einer angepassten Kurve verbundenen Punkte stellen Messwerte einer Probenmessung dar.

Damit der Laser spektral durchgestimmt werden kann, wird eine Stromrampe angelegt, die eine konstante Stromzunahme erzeugt, so dass die Temperatur und somit die Frequenz zunimmt. Dies wurde in folgender Publikation beschrieben: Nelson, D.; Shorter, J.; McManus, J.; Zahniser, M.: Sub-part-per-billion detection of nitric oxide in air using a thermoelectrically cooled mid-infrared quantum cascade laser spectrometer. Applied Physics B 2002, 75, 343-350.

Dann kann in frei gewählten (hier nahezu äquidistanten) Zeitabständen eine Absorptionsmessung durchgeführt werden, die mittels eines Vielkanalanalysators einem Kanal zugeordnet wird. Die Stromrampe kann verschiedene Formen haben: Sie kann aufsteigen, auf- und danach absteigen oder sogar oszillieren. Die gemessenen Kanäle müssen dann den echten Frequenzen (in Wellenzahlen) zugeordnet werden.

Zu diesem Zweck sind die absoluten Lagen der Absorptionspeakpositionen beispielsweise aus der HITRAN-Datenbank bekannt. Man kann also nun das gemessene Absorptionssignal in Abhängigkeit der Kanalposition so dehnen oder stauchen, dass es mit den Peakpositionen aus der HITRAN-Datenbank übereinstimmt. Das würde aber eine erhebliche Nachbearbeitung jedes einzelnen Spektrums bedeuten, bevor diese gemittelt werden könnten. Eine solche Vorgehensweise wäre aber immerhin prinzipiell möglich, allerdings sehr aufwendig.

Wenn sich allerdings die Laserparameter durch einen systematischen Temperaturdrift so weit verschieben, dass sich z.B. die Basislinie des Spektrums ändert, dann können die Messungen nicht mehr durch eine Nachbearbeitung jedes einzelnen Spektrums gemittelt werden. Das liegt daran, dass die Messung nicht mehr unter identischen Bedingungen durchgeführt wurde. Eine Mittelung würde hier zu fehlerhaften Ergebnissen führen.

Aus diesem Grund müssen die Messbedingungen und der Frequenz- und Temperaturbereich konstant, bzw. deren Abweichungen minimal gehalten werden. Um dies zu erreichen, wurde das nachfolgend beschriebene Verfahren als Ausführungsbeispiel eines Verfahrens zur Regelung der Emissionsfrequenz des Lasers entwickelt.

Der untersuchte Spektralbereich weist drei Absorptionsbanden auf. Eine $^{12}CO_2$-Absorptionsbande bei 2297,58 $cm^{-1}$ (B1), eine $^{13}CO_2$-Absorptionsbande bei 2297,19 $cm^{-1}$ (B2) und eine $^{12}CO_2$-Absorptionsbande bei 2296,45 $cm^{-1}$ (B3) (siehe Figur 2).

Um den richtigen Laserarbeitspunkt zu finden, wird die Temperatur des Lasers so eingestellt, dass er ohne Stromrampe bei einer Frequenz von etwa 2298 $cm^{-1}$ Licht emittiert. Dann wird die Stromrampe gestartet, und die Messpunkte werden bei angelegter Stromrampe aufgenommen. Angenommen die Stromrampe würde innerhalb von 1 ms den Spektralbereich um 1,7 $cm^{-1}$ durchfahren (von hohen zu niedrigeren Wellenzahlen), dann könnten in dieser Zeit sehr einfach von 20 bis 20000 Messpunkte, also 20 bis 20000 einzelne Absorptionsmessungen, durchgeführt werden, wenn die Elektronik schnell genug ist, um diese Absorptionsmessungen zu verarbeiten.

Im vorliegenden Fall wurden mehrere hundert Absorptionsmessungen durchgeführt, die bei verschiedenen Stromwerten und somit verschiedenen Emissionsfrequenzen des Lasers durchgeführt wurden. Die Aneinanderreihung der Messpunkte ergibt das in der Figur 2 gezeigte gemessene Absorptionsspektrum. Zunächst wird allerdings ein Spektrum erhalten, bei dem die Signalintensitäten noch nicht den entsprechenden Wellenzahlen, sondern nur Kanälen zugeordnet sind. Jede Messung bei einem neuen Stromwert entspricht einem neuen Kanal.

Der Position von B1 wird dem Kanal zugeordnet, bei dem das Maximum der ersten Bande (von links) identifiziert wird, die Position von B2 wird dem Kanal zugeordnet, bei dem das Maximum der zweiten Bande (von links) identifiziert wird, die Position von B3 wird dem Kanal zugeordnet, bei dem das Maximum der dritten Bande (von links) identifiziert wird.

Durch die Zuordnung der drei Banden zu den einzelnen Kanälen und einer einmaligen Etalonkalibrierung kann die Linearität bzw. Nichtlinearität der Frequenzpositionen in Abhängigkeit von den Kanälen ermittelt werden. Diese ist typischerweise gleichbleibend für einen gleichbleibenden Arbeitspunkt des Lasers (auch unter Berücksichtigung des entsprechenden Durchstimmbereichs des Lasers an diesem Arbeitspunkt). Damit ist die Stromrampe, die Anfangstemperatur, Anfangsfrequenz, die nichtlineare Abhängigkeit der Frequenz von den Kanälen für einen definierten Arbeitspunkt des Lasers charakterisiert. Zusammen mit den Einstellungen für den Betrieb des Lasers wird hierdurch der optimale Arbeitspunkt des Lasers definiert.

In den weiteren Messungen geht man nun folgendermaßen vor: Wenn (unter Idealbedingungen) keine Änderungen der Umgebungseigenschaften oder des Arbeitspunktes des Lasers vorliegen, findet keine Änderung der Laserfrequenz statt. Leider ist dies aber unter realen Bedingungen nie der Fall. Da die Lasertemperatur über eine Temperatursteuerung geregelt wird, wird grundsätzlich auf eine Eigenschaft (z.B. die Temperatur des Temperaturfühlers nahe am Laser) geregelt, die nicht exakt der Lasereigenschaft entspricht. Bei den aus dem Stand der Technik bekannten Lösungen wird die Temperatur des Lasers durch ein nahe am Laser befindliches und thermisch gut kontaktiertes Temperaturelement gemessen. Erwärmt sich der Laser, dann wird dies durch das Temperaturelement etwas verzögert und in etwas veränderter (abgeschwächter) Form gemessen. Dies liegt an der Temperaturverteilung in den Bauteilen. Das bedeutet, dass der Temperaturgradient zu einem Wärmefluss führt, der eine Temperaturänderung im Temperaturelement erzeugt, auf die dann geregelt wird.

Leider läuft eine solche Regelung immer der echten Temperatur hinterher und kann bei steigenden und fallenden Außentemperaturen zu systematischen Temperaturabweichungen führen. Dies ist insbesondere bei längerem Betrieb des Lasers oft der Fall, da sich der Laser durch den Strom- bzw. Wärmeeintrag in den Laser stetig erwärmen kann. Auch nach einem Einschalten des Lasers dauert es bis zu einer Stunde, bis der Laser in einem akzeptablen Gleichgewicht vorliegt.

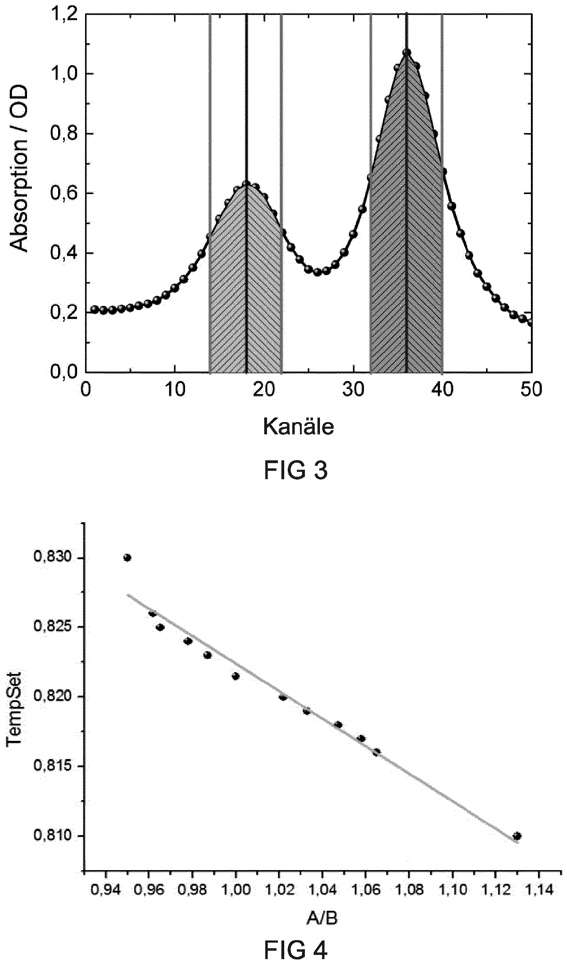

Gemäß einem Ausführungsbeispiel des vorliegend beanspruchten Verfahrens erfolgt hingegen eine direkte Verfolgung der Lage der Absorptionspeaks, wie in der Figur 3 gezeigt.

Die Figur 1 zeigt dabei eine beispielhafte Frequenzstabilisierung anhand der Lage der $CO_2$-Absorptionsbanden. Dabei werden die schraffiert dargestellten Flächen symmetrisch zum Peakmaximum der einzelnen Absorptionsbanden auf der einen Seite der jeweiligen Absorptionsbande (Kanäle mit höherer Ordnungszahl) mit der auf der anderen Seite (Kanäle mit niedrigerer Ordnungszahl) derselben Absorptionsbande durch eine Verhältnisbildung verglichen. Eine Änderung des Verhältnisses der Flächen zeigt eine Frequenzverschiebung an.

Ändert sich die Temperatur des Lasers, dann ändert sich die Emissionsfrequenz des Lasers. Folglich verschieben sich dann die Positionen der Absorptionsbanden. Ändert sich die Nichtlinearität oder die Abhängigkeit des Lasers bei Stromfluss (beispielsweise als Reaktion auf die Erwärmung), dann verschiebt sich der relative Abstand der Absorptionsbanden zueinander.

Gemäß dem beschriebenen Ausführungsbeispiel wird der Arbeitspunkt des Lasers so eingestellt, dass z.B. bei Kanal 18 und bei Kanal 36 in Figur 3 jeweils ein Peakmaximum zu finden ist. Wird nun das Signal der Kanäle von 14 bis 18 als Parameter A und das Signal der Kanäle von 18 bis 22 als Parameter B jeweils integriert und das Verhältnis der Integrale I1 = A/B gebildet, dann gibt ein Anstieg von I1 eine Verschiebung des Peaks zu niedrigeren Kanälen und ein Abfall von I1 eine Verschiebung des Peaks zu höheren Kanälen an.

Analog verfährt man mit dem zweiten Peak. Wird nun das Signal der Kanäle von 32 bis 36 als Parameter C und das Signal der Kanäle von 36 bis 40 als Parameter D jeweils integriert und das Verhältnis der Integrale I2 = C/D gebildet, dann gibt ein Anstieg von I2 eine Verschiebung des Peaks zu niedrigeren Kanälen und ein Abfall von I2 eine Verschiebung des Peaks zu höheren Kanälen an.

Die Integration der Flanken der Absorptionsbanden ist eine Möglichkeit, die Verschiebung der Maxima der Absorptionsbanden aus den Verhältnissen zu berechnen. Sie hat den Vorteil, dass bei der Integration das Signal-Rausch-Verhältnis steigt und man selbst bei verrauschten Spektren die Verschiebung der Maxima der Absorptionsbanden gut bestimmen kann.

Man kann unterschiedliche Flankenanteile mit in die Integration einbeziehen, die nicht unbedingt symmetrisch angeordnet sein müssen. Es können Flanken bis 90% des Maximums, insbesondere bis 80%, insbesondere bis 70%, insbesondere bis 60%, insbesondere bis 50%, insbesondere bis 40%, insbesondere bis 30%, insbesondere bis 20%, insbesondere bis 1 0% einbezogen werden. Je spektral isolierter die Banden sind, d.h. je weniger Überlapp mit anderen Banden besteht, desto größer kann sinnvollerweise der in die Integration der Flanken einbezogene Flankenanteil werden. Andere Möglichkeiten zur Ermittlung, ob es zu einer Verschiebung der Maxima der Absorptionsbanden gekommen ist, bestehen aber auch, z.B. durch Auswertung der Wendepunkte und des Maximums, etc.

Eine Verschiebung beider Peaks kann durch eine veränderte Anfangstemperatur oder Anfangsfrequenz auftreten. Diese wird in der Regelung des vorliegend beschriebenen Ausführungsbeispiels mit dem Wert TempSet angegeben (Verschiebung des Spektrums). Ist der relative Abstand der Peakpositionen verändert, dann hat sich die Nichtlinearität zwischen der Frequenz und den Kanälen geändert. Dies wird in der Regelung des vorliegend beschriebenen Ausführungsbeispiels mit dem Wert Imax angegeben. Der Stromfluss wird während einer kompletten Rampe von Null auf Imax erhöht. Eine Veränderung von Imax entspricht einer Stauchung bzw. Dehnung des Spektrums.

Eine Veränderung einer oder beider Peakpositionen wird direkt nach der Messung eines Spektrums durch Variation von TempSet und Imax korrigiert. Da das Absorptionsspektrum den aktuellen Arbeitspunkt des Lasers direkt widerspiegelt, kann der Arbeitspunkt direkt in einer Feedback-Regelung optimiert werden.

Der Wert TempSet ist ein Wert, der den Arbeitspunkt des Lasers definiert. Die Änderung des TempSet-Wertes ΔTempSet ist in der nachfolgenden Tabelle beschrieben und ergibt sich aus den Flankenintegralen A und B der betrachteten Absorptionsbande.

Der Wert Imax ist ebenfalls ein Wert, der den Arbeitspunkt des Lasers definiert. Die Änderung des Imax-Wertes ΔImax ist in der nachfolgenden Tabelle beschrieben und ergibt sich aus den Flankenintegralen C und D der betrachteten Absorptionsbande.

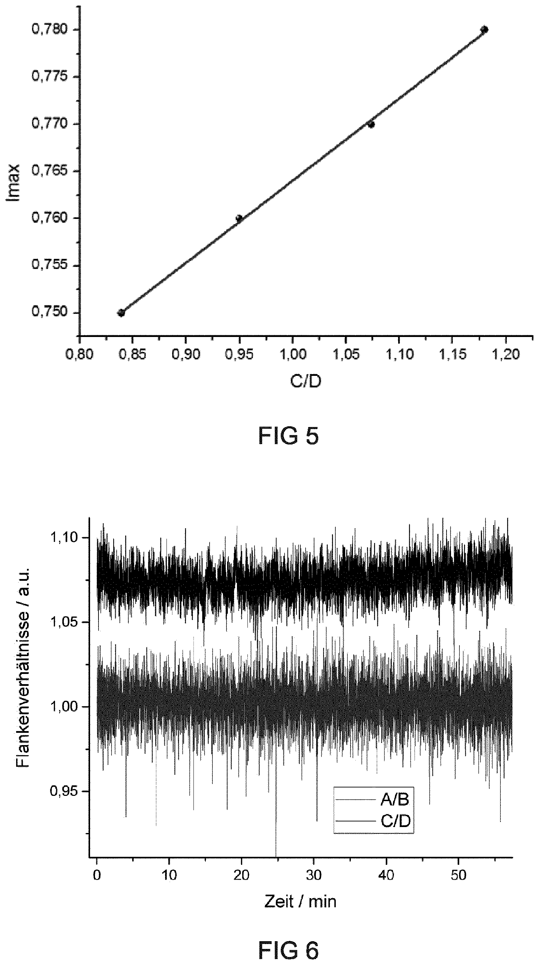

Die Abhängigkeit der Steigungen α und δ werden beim Einstellungsprozess des optimalen Arbeitspunktes bestimmt. Der Wert α kann beispielsweise aus einer Auftragung des Parameters TempSet über das Verhältnis A/B ermittelt werden, wie sie in der Figur 4 dargestellt ist. Der Wert δ kann beispielsweise aus einer Auftragung des Parameters Imax über das Verhältnis C/D ermittelt werden, wie sie in der Figur 5 dargestellt ist. Hierbei werden die Parameter TempSet und Imax unabhängig voneinander an den optimalen Punkten der anderen Werte vermessen.

Nachfolgend werden drei Regelungen beispielhaft dargestellt.

Beispiel 1

Eine Geradengleichung wird zur Korrektur des Arbeitspunktes und der Stauchung des Spektrums verwendet. Die beiden Regelgrößen sind entkoppelt voneinander.

| Verschiebung des gesamten Spektrums | Stauchung des Spektrums |
|---|---|
| $$\Delta Temp\_Set = \left(\alpha\left(\frac{A}{B}-1\right)\right) * Faktor\ LNR$$ | $$\Delta I\_max = \left(\delta\left(\frac{C}{D}-1\right)\right) * Faktor\ LNR$$ |
| $Temp\_Set_{Neu} = Temp\_Set_{Alt} + \Delta Temp\_Set$ | $I\_max_{Neu} = I\_max_{Alt} + \Delta I\_max$ |
| α: Anstieg von TempSet vs. A/B | δ: Anstieg von I_max vs. C/D |

(fortgesetzt)

| Verschiebung des gesamten Spektrums | Stauchung des Spektrums |
|---|---|
| A, B: linke bzw. rechte Fläche von Peak; Summe über Kanäle links bzw. rechts des festgelegten zentralen Kanals<br><br>LNR: Korrekturfaktor -> Festlegung über Standardabweichung von A/B und C/D bei aktiver Regelung; typische Werte: 0,01; 0,05; 0,1<br><br>Temp_Set: Wert, welcher an den Regelkreis der Elektronik gegeben wird | C, D: linke bzw. rechte Flächen von Peak; Summe über Kanäle links bzw. rechts des festgelegten zentralen Kanals<br><br>LNR: Korrekturfaktor -> Festlegung über Standardabweichung von A/B und C/D bei aktiver Regelung; typische Werte: 0,01; 0,05; 0,1<br><br>I_max: Wert, welcher an den Regelkreis der Elektronik gegeben wird |

In der hier aufgeführten Regelung werden die Positionen von zwei Absorptionspeaks (P1 und P2) über eine Feedback-Regelung geregelt. Die TempSet-Einstellung soll die Position des Peaks P1 so einstellen, dass das Maximum im Kanal K1 liegt. Die Steigung $\alpha$ beschreibt nun die Änderung des Wertes TempSet in Abhängigkeit von dem Flankenverhältnis A/B. Das Verhältnis A/B beschreibt die Integrale der linken zur rechten Flanke des Peaks P1. Bei einer Verschiebung des Peaks ändert sich das Verhältnis A/B. In dem in der Tabelle dargestellten Beispiel ist der Peak P1 am gewünschten Kanal positioniert, wenn das Verhältnis 1 ist. Weicht das Verhältnis von 1 ab, dann ergibt sich ein Korrekturwert aus (A/B-1). Dieser wird mit der Steigung $\alpha$ multipliziert und dient damit der exakten Einstellung des für die gewünschte Arbeitstemperatur des Lasers benötigten TempSet-Werts.

Die Imax-Einstellung soll die Position des Peaks P2 so einstellen, dass das Maximum im Kanal K2 liegt. Die Steigung $\delta$ beschreibt nun die Änderung des Wertes Imax in Abhängigkeit von dem Flankenverhältnis C/D. Das Verhältnis C/D beschreibt die Integrale der linken zur rechten Flanke des Peaks P2. Bei einer Verschiebung des Peaks ändert sich das Verhältnis C/D. In dem in der Tabelle dargestellten Beispiel ist der Peak P2 am gewünschten Kanal positioniert, wenn das Verhältnis 1 ist. Weicht das Verhältnis von 1 ab, dann ergibt sich ein Korrekturwert aus (C/D-1). Dieser wird mit der Steigung $\delta$ multipliziert und dient damit der exakten Einstellung des für die gewünschte Arbeitstemperatur des Lasers benötigten Imax-Werts.

Da allerdings sehr oft noch eine zusätzliche Temperaturregelung die Lasertemperatur regelt, ist es in der Praxis oftmals sinnvoll, die Regelungsschritte der Feedback-Regelung anzupassen und kleiner als 1 zu wählen. Des Weiteren muss berücksichtigt werden, dass die Steigungen $\alpha$ und $\delta$ einen statistischen Fehler aufweisen, der in der Größe der Regelungsschritte mit einbezogen werden muss. Dieser Fehler wird in einem Kalibrierschritt quantifiziert. Dazu wird die Standardabweichung der Streuung des Verhältnisses A/B in Abhängigkeit des Faktors LNR bei aktiver Regelung bestimmt. Beide zuvor genannten Einflussfaktoren werden durch den LNR-Faktor berücksichtigt. Im idealen Fall wäre LNR gleich eins.

Durch die vorstehend beispielhaft dargestellte Regelung der Emissionsfrequenz eines Lasers ist es möglich, sehr stabile Positionen von Absorptionsbanden in einem Spektrum zu erhalten. Dies ist beispielhaft in der Figur 6 dargestellt, die Verläufe der Flankenverhältnisse A/B (obere Linie) und C/D (untere Linie) in Abhängigkeit von der Zeit bei einer Messung in einer klinischen Umgebung mit schwankenden Temperaturverhältnissen zeigt. Die Flankenverhältnisse sind im Mittel sehr konstant, da die vorstehend erläuterte Regelung der Emissionsfrequenz des Lasers angewandt wurde. Ohne eine derartige Regelung der Emissionsfrequenz würden sich die Flankenverhältnisse massiv ändern, was einer Verschiebung der betrachteten Absorptionsbanden im Spektrum entspräche. Hierbei spielt es keine Rolle, ob die geregelten Verhältnisse bei eins liegen oder davon abweichen. Für eine Stabilisierung der Frequenz ist nur ein konstanter Mittelwert der Verhältnisse mit kleinen Abweichungen (geringer Standardabweichung) wichtig, um die Emissionsfrequenz erfolgreich zu regeln.

Beispiel 2

Eine Geradengleichung wird zur Korrektur des Arbeitspunktes und der Stauchung des Spektrums verwendet. Die beiden Regelgrößen sind gekoppelt.

| Verschiebung des Spektrums | Stauchung des Spektrums |
|---|---|
| $$\Delta Temp\_Set = \left(\alpha'\left(\frac{A}{B}-1\right) + \beta'(TempSet(I_{max}))\right) * Faktor\ LNR$$ | $$\Delta I\_max = \left(\gamma'\left(\frac{A}{B}-1\right) + \delta'(I_{max}(TempSet))\right) * Faktor\ LNR$$ |
| $Temp\_Set_{Neu} = Temp\_Set_{Alt} + \Delta Temp\_Set$ | $I\_max_{Neu} = I\_max_{Alt} + \Delta I\_max$ |
| $\alpha'$: Anstieg von TempSet vs. A/B<br>$\beta'$: Abhängigkeit von TempSet bei Änderung von Imax<br>A, B: linke bzw. rechte Fläche von Peak; Summe über Kanäle links bzw. rechts des festgelegten zentralen Kanals LNR: Korrekturfaktor -> Festlegung über Standardabweichung von A/B und C/D bei aktiver Regelung; typische Werte: 0,01; 0,05; 0,1<br>Temp_Set: Wert, welcher an den Regelkreis der Elektronik gegeben wird | $\delta'$: Anstieg von I_max vs. C/D<br>$\gamma'$: Abhängigkeit von I_max bei Änderung von TempSet<br>C, D: linke bzw. rechte Flächen von Peak; Summe über Kanäle links bzw. rechts des festgelegten zentralen Kanals LNR: Korrekturfaktor -> Festlegung über Standardabweichung von A/B und C/D bei aktiver Regelung; typische Werte: 0,01; 0,05; 0,1<br>I_max: Wert, welcher an den Regelkreis der Elektronik gegeben wird |

In der hier aufgeführten Regelung werden die Positionen von zwei Absorptionspeaks (P1 und P2) über eine Feedback-Regelung geregelt. Die TempSet-Einstellung soll die Position des Peaks P1 so einstellen, dass das Maximum im Kanal K1 liegt. Die Steigung $\alpha'$ beschreibt nun die Änderung des Wertes TempSet in Abhängigkeit von dem Flankenverhältnis A/B. $\beta'$ beschreibt die Änderung des Wertes von TempSet bei Änderung von Imax. Das Verhältnis A/B beschreibt die Integrale der linken zur rechten Flanke des Peaks P1. Bei einer Verschiebung des Peaks ändert sich das Verhältnis A/B. In dem in der Tabelle dargestellten Beispiel ist der Peak P1 am gewünschten Kanal positioniert, wenn das Verhältnis z.B. 1 ist. Weicht das Verhältnis von z.B. 1 ab, dann ergibt sich ein Korrekturwert aus (A/B-1). Dieser wird mit der Steigung $\alpha'$ multipliziert. Da in demselben oder einem darauffolgendem Regelungsschritt Imax eingestellt wird, würde diese Positionsverschiebung die Position von P1 mit beeinflussen. Um diesem entgegenzuwirken, wird ein zusätzlicher Term $\beta'$ eingeführt, der diese Abhängigkeit von Imax berücksichtigt.

Die Imax-Einstellung soll die Position des Peaks P2 so einstellen, dass das Maximum im Kanal K2 liegt. Die Steigung $\gamma'$ beschreibt nun die Änderung des Wertes Imax in Abhängigkeit von dem Flankenverhältnis C/D. $\delta'$ beschreibt die Abhängigkeit des Wertes von Imax bei Änderung von TempSet. Das Verhältnis C/D beschreibt die Integrale der linken zur rechten Flanke des Peaks P2. Bei einer Verschiebung des Peaks ändert sich das Verhältnis C/D. In dem in der Tabelle dargestellten Beispiel ist der Peak P2 am gewünschten Kanal positioniert, wenn das Verhältnis z.B. 1 ist. Weicht das Verhältnis von z.B. 1 ab, dann ergibt sich ein Korrekturwert aus (C/D-1). Dieser wird mit der Steigung $\delta'$ multipliziert. Da in demselben oder einem darauffolgendem Regelungsschritt TempSet eingestellt wird, würde diese Positionsverschiebung die Position von P2 mit beeinflussen. Um diesem entgegenzuwirken, wird ein zusätzlicher Term $\delta'$ eingeführt, der diese Abhängigkeit von dem TempSet definiert.

Die Korrektur der einzelnen Werte für TempSet und Imax können dabei zeitgleich (parallel) oder hintereinander (sequentiell) durchgeführt werden. Für eine parallele Ausführung der Regelung müssen für die Größen TempSet(Imax) und Imax(TempSet) die vollständigen Kurvenscharen aufgenommen werden. Im Falle einer sequentiellen Ausführung (Korrektur von TempSet gefolgt von Imax) lässt sich eine Fallunterscheidung treffen: Ist der relative Fehler $\Delta Temp\text{-}Set/TempSet \geq \Delta Imax/Imax$, also der Einfluss der Änderung auf die Position von Peak P1 größer als auf Peak P2, so kann $\beta'$ gleich Null gesetzt werden, wodurch der Wert für TempSet so geändert wird, das der Peak P1 im Kanal K1 sein Maximum hat. P2 wird entsprechend obiger Formel korrigiert, jedoch wird die Verschiebung des Peaks P2 aufgrund der Änderung von TempSet mit berücksichtigt. Ist der relative Fehler $\Delta Imax/Imax \geq \Delta TemSet/TemSet$, also der Einfluss der Änderung auf die Position von Peak P2 größer als auf Peak P1, so kann $\delta'$ gleich Null gesetzt werden, wodurch der Wert für Imax so geändert wird, das der Peak P2 im Kanal K2 sein Maximum hat. P1 wird entsprechend obiger Formel korrigiert, jedoch wird die Verschiebung des Peaks P1 aufgrund der Änderung von Imax mit berücksichtigt. Ein "Übersteuern" der Regelung ist nicht möglich.

Da allerdings sehr oft noch eine zusätzliche Temperaturregelung die Lasertemperatur regelt, ist es in der Praxis oftmals sinnvoll, die Regelungsschritte der Feedback-Regelung anzupassen und kleiner als 1 zu wählen. Des Weiteren muss berücksichtigt werden, dass die Steigungen $\alpha$ und $\delta$ einen statistischen Fehler aufweisen, der in der Größe der Regelungsschritte mit einbezogen werden muss. Des Weiteren muss berücksichtigt werden, dass die Steigungen $\alpha'$,

$\delta$', $\beta$' und $\gamma$' einen statistischen Fehler aufweisen, der in der Größe der Regelungsschritte mit einbezogen werden muss. Dieser Fehler wird in einem Kalibrierschritt quantifiziert. Dazu wird die Standardabweichung der Streuung des Verhältnisses A/B in Abhängigkeit des Faktors LNR bei aktiver Regelung bestimmt. Beide zuvor genannten Einflussfaktoren werden durch den LNR-Faktor berücksichtigt. Im idealen Fall wäre LNR gleich eins.

Beispiel 3:

Es werden Intervalle vorgegeben, in denen die Feedbackschleife geregelt wird.

| $A/B > (a_i * Peakabweichung_{AB} + 1)$ | $C/D > (c_j * Peakabweichung_{CD} + 1)$ |
|---|---|
| $B/A > (a_i * Peakabweichung_{AB} + 1)$ | $D/C > (c_j * Peakabweichung_{CD} + 1)$ |
| **$Temp\_Set_{Neu} = Temp\_Set_{alt} \pm b_i$** | **$I\_max = I\_max \pm d_j$** |
| A, B: linke bzw. rechte Fläche von Peak; Summe über Kanäle links bzw. rechts des festgelegten zentralen Kanals | C,D: linke bzw. rechte Fläche von Peak; Summe über Kanäle links bzw. rechts des festgelegten zentralen Kanals |
| $a_i$, $b_i$: voreingestellte Parameter für Intervall i | $c_j$, $d_j$: voreingestellte Parameter für Intervall j |
| $Peakabweichung_{AB}$: voreingestellter Parameter | $Peakabweichung_{CD}$: voreingestellter Parameter |
| Temp_Set: Wert, welcher an den Regelkreis der Elektronik gegeben wird | I_max: Wert, welcher an den Regelkreis der Elektronik gegeben wird |
| Für jedes Intervall i können andere Parameter für $a_i$ und $b_i$ verwendet werden | Für jedes Intervall j können andere Parameter für $a_j$ und $b_j$ verwendet werden |

Die dritte Regelung ist unabhängig von einer vorher bestimmten Abhängigkeit von TempSet von A/B oder Imax von C/D.

In dieser Variante werden zwei Peakpositionen P1 und P2 den Kanälen K1 und K2 zugeordnet. Für die Abweichung der Werte der Verhältnisse von A/B und C/D um einen vorgegebenen Wert, z.B. 1, lassen sich Intervalle definieren, für die TempSet um einen festgelegten Wert verändert wird. Diese Intervalleinteilung wird durch den Wert $Peakabweichung_{AB} * \alpha$ dargestellt. Für kleine Änderungen am Wert TempSet ist ein Intervall ($Peakabweichung_{AB} * \alpha_1$) ausreichend. So wird bei einer Abweichung von A/B von z.B. dem Wert. 1, die größer ist als der Wert $Peakabweichung_{AB} * \alpha_1$, der Wert TempSet um den Betrag ($+b_1$) verändert. Der Wert für $Peakabweichung_{AB}$ ist sehr klein und kann bei 0,002 liegen. Wenn $\alpha_1$ z.B. den Wert eins hat, dann wird bei einer Abweichung von 0,002 der Wert TempSet um $b_1$ verändert (z.B. 0,0005). Für größere Abweichungen können weitere Intervalle definiert werden. Die Intervalle können müssen aber nicht äquidistant sein. So können für die Intervalle $Peakabweichung_{AB} * \alpha_2$ (z.B. Wert zwei), $Peakabweichung_{AB} * \alpha_3$ (z.B. Wert drei) und $Peakabweichung_{AB} * \alpha_4$ (z.B. Wert fünf) größere $b_2$, $b_3$, $b_4$ Werte für die Änderungen von TempSet gewählt werden. Innerhalb eines Intervalls (Werte zwischen $Peakabweichung_{AB} * \alpha_i$ und $Peakabweichung_{AB} * \alpha_{i-1}$) wird TempSet stets um einen für dieses Intervall festen Betrag ($b_i$) korrigiert. Liegt der Wert in einem anderen Intervall, so wird TempSet um einen anderen Betrag $b_i$ korrigiert. Für jedes Intervall gibt es ein definiertes $b_i$.

Die Regelung wird iterativ ausgeführt. Das heißt, dass in einem ersten Regelungsschritt das Verhältnis A/B bestimmt wird und gegen die festgelegten Intervalle verglichen wird. Je nachdem in welchem Intervall das Verhältnis A/B liegt, wird der Wert für TempSet um den entsprechenden Wert $b_i$ korrigiert. In einem darauffolgenden Schritt wird diese Vorgehensweise wiederholt und gegebenenfalls TempSet erneut korrigiert. Durch ein Hintereinanderausführen dieser Einzelschritte ergibt sich eine Regelschleife, durch die die Peakposition P1 pro Durchlauf der Schleife korrigiert wird mit dem Ziel, das Verhältnis A/B innerhalb des kleinsten Intervalls und somit Peakposition P1 an Kanal K1 zu belassen.

Mit dieser Methode können Abweichungen zu niedrigeren oder höheren Temperaturen mit unterschiedlichen Regelungsschritten eingeführt werden. Dies ist sinnvoll, wenn die Kühlung des Lasers nahe am Limit läuft und z.B. eine Kühlung länger dauert als eine Erwärmung.

Die Abweichung B/A zeigt eine Peakabweichung in die andere Richtung als A/B. Dementsprechend wird TempSet analog der zuvor beschriebenen Methode in die andere Richtung geregelt ($TempSet_{neu}=TempSet_{alt}-b_i$).

Der zweite Peak P2 wird auf den Kanal K2 geregelt. Die Vorgehensweise ist analog zur Regelung von TempSet. Allerdings werden die Intervalle, ab wann geregelt wird ($c_1$, $c_2$, $c_3$, $c_4$, etc.) und wieviel geregelt wird ($d_1$, $d_2$, $d_3$, $d_4$, etc.), sowie die $Peakabweichung_{CD}$ separat für Imax aus dem Verhältnissen C/D und D/C bestimmt.

**Patentansprüche**

1. Verfahren zur Regelung der Emissionsfrequenz eines Lasers, wobei das Verfahren die folgenden Schritte aufweist:

   a) Aufnehmen eines ersten Spektrums, indem ein von dem Laser emittiertes Laserlicht durch eine Probe hindurch auf einen Detektor geleitet wird, wobei der Detektor mit einem Vielkanalanalysator verbunden ist, der von dem Detektor detektierte Impulse einem Kanal zuordnet,
   b) Bestimmen eines ersten Kanals, dem das Maximum eines ersten Signals in dem ersten Spektrum zugeordnet wurde,
   c) Bestimmen eines zweiten Kanals, dem das Maximum eines zweiten Signals in dem ersten Spektrum zugeordnet wurde,
   d) Aufnehmen eines zweiten Spektrums in analoger Weise wie das erste Spektrum,
   e) Ermitteln, ob das Maximum des ersten Signals in dem zweiten Spektrum dem ersten Kanal zugeordnet wurde und ob das Maximum des zweiten Signals in dem zweiten Spektrum dem zweiten Kanal zugeordnet wurde,
   f) Anpassen einer Arbeitstemperatur des Lasers bei in Schritt e) ermittelten Abweichungen derart, dass das Maximum des ersten Signals in dem zweiten Spektrum dem ersten Kanal zugeordnet wird und/oder dass das Maximum des zweiten Signals in dem zweiten Spektrum dem zweiten Kanal zugeordnet wird.

2. Verfahren nach Anspruch 1, **dadurch gekennzeichnet, dass** bei in Schritt e) ermittelten Abweichungen zusätzlich ein Laserparameter angepasst wird, der eine Dehnung oder Stauchung eines mithilfe des Lasers aufgenommenen Spektrums bewirkt.

3. Verfahren nach Anspruch 1 oder 2, **dadurch gekennzeichnet, dass** zum Ermitteln in Schritt f) folgendes durchgeführt wird:

   • Bestimmen eines ersten Werts für den ersten Kanal und für eine vorbestimmbare Anzahl dem ersten Kanal benachbarter Kanäle mit höherer Ordnungszahl, wobei der erste Wert eine diesen Kanälen zugeordnete Signalintensität repräsentiert,
   • Bestimmen eines zweiten Werts für den ersten Kanal und für eine vorbestimmbare Anzahl dem ersten Kanal benachbarter Kanäle mit niedrigerer Ordnungszahl, wobei der zweite Wert eine diesen Kanälen zugeordnete Signalintensität repräsentiert, und
   • Bilden eines ersten Verhältnisses zwischen dem ersten Wert und dem zweiten Wert.

4. Verfahren nach Anspruch 3, **dadurch gekennzeichnet, dass** das erste Verhältnis dazu verwendet wird, einen Temperaturregelparameter des Lasers anzupassen.

5. Verfahren nach einem der vorherigen Ansprüche, **dadurch gekennzeichnet, dass** zum Ermitteln in Schritt e) folgendes durchgeführt wird:

   • Bestimmen eines dritten Werts für den zweiten Kanal und für eine vorbestimmbare Anzahl dem zweiten Kanal benachbarter Kanäle mit höherer Ordnungszahl, wobei der dritte Wert eine diesen Kanälen zugeordnete Signalintensität repräsentiert,
   • Bestimmen eines vierten Werts für den zweiten Kanal und für eine vorbestimmbare Anzahl dem zweiten Kanal benachbarter Kanäle mit niedrigerer Ordnungszahl, wobei der vierte Wert eine diesen Kanälen zugeordnete Signalintensität repräsentiert, und
   • Bilden eines zweiten Verhältnisses zwischen dem dritten Wert und dem vierten Wert.

6. Verfahren nach Anspruch 5, **dadurch gekennzeichnet, dass** das zweite Verhältnis dazu verwendet wird, einen Laserparameter anzupassen, der eine Dehnung oder Stauchung eines mithilfe des Lasers aufgenommenen Spektrums bewirkt.

7. Verfahren nach einem der Ansprüche 3 bis 6, **dadurch gekennzeichnet, dass** die Anzahl benachbarter Kanäle mit niedrigerer Ordnungszahl der Anzahl benachbarter Kanäle mit höherer Ordnungszahl entspricht.

8. Verfahren nach Anspruch 1 oder 2, **dadurch gekennzeichnet, dass** zum Ermitteln in Schritt e) folgendes durchgeführt wird:

   • Bestimmen eines dritten Kanals, dem das Maximum des ersten Signals in dem zweiten Spektrum zugeordnet wurde, und/oder

• Bestimmen eines vierten Kanals, dem das Maximum des zweiten Signals in dem zweiten Spektrum zugeordnet wurde, und

• Ermitteln, ob der dritte Kanal dem ersten Kanal und/oder ob der vierte Kanal dem zweiten Kanal entspricht.

**9.** Verfahren nach Anspruch 8, **dadurch gekennzeichnet, dass** das Bestimmen des dritten Kanals und/oder des vierten Kanals durch ein Anpassen einer Kurve an Messwerte des zweiten Spektrums erfolgt, wobei ein dem Maximum des ersten Signals entsprechendes Maximums der Kurve für die Bestimmung des dritten Kanals verwendet wird und/oder ein dem Maximum des zweiten Signals entsprechendes Maximums der Kurve für die Bestimmung des vierten Kanals verwendet wird.

**Claims**

**1.** Method for controlling the emission frequency of a laser, wherein the method comprises the following steps:

a) recording a first spectrum by passing a laser light emitted by the laser through a sample onto a detector, the detector being connected to a multichannel analyzer which assigns pulses detected by the detector to a channel,

b) determining a first channel to which the maximum of a first signal in the first spectrum has been assigned,

c) determining a second channel to which the maximum of a second signal in the first spectrum has been assigned,

d) recording a second spectrum in the same way as the first spectrum,

e) determining whether the maximum of the first signal in the second spectrum was assigned to the first channel and whether the maximum of the second signal in the second spectrum was assigned to the second channel,

f) adaptation of a working temperature of the laser with deviations determined in step e) such that the maximum of the first signal in the second spectrum is assigned to the first channel and/or that the maximum of the second signal in the second spectrum is assigned to the second channel.

**2.** Method according to claim 1, **characterized in that**, in the case of deviations determined in step e), a laser parameter is additionally adapted which causes an extension or compression of a spectrum recorded with the aid of the laser.

**3.** A method according to claim 1 or 2, **characterized in that** the following is carried out for determining in step f):

• determining a first value for the first channel and for a predeterminable number of higher order channels adjacent the first channel, the first value representing a signal intensity assigned to these channels,

• determining a second value for the first channel and for a predeterminable number of lower order channels adjacent the first channel, the second value representing a signal intensity assigned to these channels, and

• forming a first ratio between the first value and the second value.

**4.** A method according to claim 3, **characterized in that** the first ratio is used to adjust a temperature control parameter of the laser.

**5.** A method according to any of the previous claims, **characterized in that** the following is carried out for determining in step e):

• determining a third value for the second channel and for a predeterminable number of higher order channels adjacent the second channel, the third value representing a signal intensity assigned to these channels,

• determining a fourth value for the second channel and for a predeterminable number of lower order channels adjacent the second channel, the fourth value representing a signal intensity assigned to these channels, and

• forming a second ratio between the third value and the fourth value.

**6.** A method according to claim 5, **characterized in that** the second ratio is used to adjust a laser parameter which causes an elongation or compression of a spectrum recorded with the aid of the laser.

**7.** A method according to any of claims 3 to 6, **characterized in that** the number of adjacent lower order channels corresponds to the number of adjacent higher order channels.

**8.** Method according to claim 1 or 2, **characterized in that** the following is carried out for determining in step e):

• determining a third channel to which the maximum of the first signal in the second spectrum has been assigned, and/or

• determining a fourth channel to which the maximum of the second signal in the second spectrum has been assigned, and

• determining whether the third channel corresponds to the first channel and/or whether the fourth channel corresponds to the second channel.

**9.** Method according to claim 8, **characterized in that** the determination of the third channel and/or the fourth channel is carried out by adapting a curve to measured values of the second spectrum, wherein a maximum of the curve corresponding to the maximum of the first signal is used for the determination of the third channel and/or a maximum of the curve corresponding to the maximum of the second signal is used for the determination of the fourth channel.

**Revendications**

**1.** Procédé de régulation de la fréquence d'émission d'un laser, dans lequel le procédé présente les étapes suivantes :

a) d'enregistrement d'un premier spectre en ce qu'une lumière laser émise par le laser est dirigée à travers un échantillon sur un détecteur, dans lequel le détecteur est raccordé à un analyseur multicanaux, qui associe des impulsions détectées par le détecteur à un canal,
b) de définition d'un premier canal, auquel le maximum d'un premier signal a été associé dans le premier spectre,
c) de définition d'un deuxième canal, auquel le maximum d'un deuxième signal a été associé dans le premier spectre,
d) d'enregistrement d'un deuxième spectre de manière analogue au premier spectre,
e) de détermination pour savoir si le maximum du premier signal dans le deuxième spectre a été associé au premier canal et si le maximum du deuxième signal dans le deuxième spectre a été associé au deuxième canal,
f) d'adaptation d'une température de travail du laser en cas d'écarts déterminés à l'étape e) de telle manière que le maximum du premier signal dans le deuxième spectre est associé au premier canal et/ou que le maximum du deuxième signal dans le deuxième spectre est associé au deuxième canal.

**2.** Procédé selon la revendication 1, **caractérisé en ce qu'**un paramètre de laser est adapté en supplément en cas d'écarts déterminés dans l'étape e), qui entraîne un allongement ou un tassement d'un spectre enregistré à l'aide du laser.

**3.** Procédé selon la revendication 1 ou 2, **caractérisé en ce que** pour la détermination effectuée dans l'étape f), ce qui suit est mis en oeuvre :

- la définition d'une première valeur pour le premier canal et pour un nombre pouvant être prédéfini de canaux adjacents au premier canal avec un numéro d'ordre plus élevé, dans lequel la première valeur représente une intensité de signal associée auxdits canaux,
- la définition d'une deuxième valeur pour le premier canal et pour un nombre pouvant être prédéfini de canaux adjacents au premier canal avec un numéro d'ordre plus bas, dans lequel la deuxième valeur représente une intensité de signal associée auxdits canaux, et
- l'obtention d'un premier rapport entre la première valeur et la deuxième valeur.

**4.** Procédé selon la revendication 3, **caractérisé en ce que** le premier rapport est utilisé pour adapter un paramètre de régulation de température du laser.

**5.** Procédé selon l'une quelconque des revendications précédentes, **caractérisé en ce que** pour la détermination effectuée dans l'étape e), ce qui suit est mis en oeuvre :

- la définition d'une troisième valeur pour le deuxième canal et pour un nombre pouvant être prédéfini de canaux adjacents au deuxième canal avec un numéro d'ordre plus élevé, dans lequel la troisième valeur représente une intensité de signal associée auxdits canaux,
- la définition d'une quatrième valeur pour le deuxième canal et pour un nombre pouvant être prédéfini de canaux adjacents au deuxième canal avec un numéro d'ordre plus bas, dans lequel la quatrième valeur représente l'intensité de signal associée auxdits canaux, et
- l'obtention d'un deuxième rapport entre la troisième valeur et la quatrième valeur.

**6.** Procédé selon la revendication 5, **caractérisé en ce que** le deuxième rapport est utilisé pour adapter un paramètre de laser, qui entraîne un allongement ou un tassement d'un spectre enregistré à l'aide du laser.

**7.** Procédé selon l'une quelconque des revendications 3 à 6, **caractérisé en ce que** le nombre de canaux adjacents avec un numéro d'ordre plus bas correspond au nombre de canaux adjacents avec un numéro d'ordre plus élevé.

**8.** Procédé selon la revendication 1 ou 2, **caractérisé en ce que** pour la détermination effectuée dans l'étape e), ce qui suit est mis en oeuvre :

- la définition d'un troisième canal, auquel le maximum du premier signal a été associé dans le deuxième spectre, et/ou
- la définition d'un quatrième canal, auquel le maximum du deuxième signal a été associé dans le deuxième spectre, et
- la détermination pour savoir si le troisième canal correspond au premier canal et/ou si le quatrième canal correspond au deuxième canal.

**9.** Procédé selon la revendication 8, **caractérisé en ce que** la définition du troisième canal et/ou du quatrième canal est effectuée par une adaptation d'une courbe à des valeurs de mesure du deuxième spectre, dans lequel un maximum de la courbe correspondant au maximum du premier signal est utilisé pour la définition du troisième canal, et/ou un maximum de la courbe correspondant au maximum du deuxième signal est utilisé pour la définition du quatrième canal.

FIG 1

FIG 2

FIG 3

FIG 4

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0845166 B1
- US 20020097760 A1
- US 20030174743 A1

**In der Beschreibung aufgeführte Nicht-Patentliteratur**

- **O. STROBEL ; N. GRAF.** AUTOMATIC START-UP PROCEDURE FOR LASER WAVELENGTH STABILIZATION. *5th INTERNATIONAL CONFERENCE ON INTEGRATED OPTICS AND OPTICAL FIBRE COMMUNICATION, 11th EUROPEAN CONFERENCE ON OPTICAL COMMUNICATION, Venezia,* 01. Oktober 1985, 413-416

- **NELSON, D. ; SHORTER, J. ; MCMANUS, J. ; ZAHNISER, M.** Sub-part-per-billion detection of nitric oxide in air using a thermoelectrically cooled mid-infrared quantum cascade laser spectrometer. *Applied Physics B,* 2002, vol. 75, 343-350